# EUROPEAN PATENT APPLICATION

(11) **EP 2 421 047 A1**
(43) Date of publication of application: **22.02.2012**
(21) Application number: 11159170.7
(22) Date of filing: 22.03.2011
(51) Int. Cl.: H01L 29/78, H01L 29/739, H01L 21/336, H01L 29/06

(54) **Semiconductor device and method for manufacturing same**

(30) Priority: 18.08.2010 JP 2010183398
(71) Applicant: Kabushiki Kaisha Toshiba, Tokyo 105-8001 (JP)
(72) Inventor: Sato, Shingo, Tokyo 105-8001 (JP); Shinohara, Hitoshi, Tokyo 105-8001 (JP); Kawamura, Keiko, Tokyo 105-8001 (JP)
(74) Representative: HOFFMANN EITLE

(57) **Abstract**

A semiconductor device (110) includes a first semiconductor region (10), a second semiconductor region (20), a third semiconductor region (30), a fourth semiconductor region (40), a gate region (50), a gate insulating film (60), and an electric field relaxation region (70). The first semiconductor regian (10) includes a first portion (11) and a second portion (12), the first portion having a first major surface (11a), the second portion extending in a first direction orthogonal to the first major surface. The second semiconductor region (20) includes a third portion (23) and a fourth portion (24) adjacent to the second portion. The third semiconductor region (30) includes a fifth portion (35) and a sixth portion (36) adjacent to the fourth portion. The fourth semiconductor region (40) is adjacent to the sixth portion (36). The gate region (50) is provided inside a trench (100T) made in a second direction orthogonal to the first direction. The gate insulating film (60) is provided between the gate region (50) and an inner wall of the trench (100T). The electric field relaxation region (70) is provided between the third portion (23) and the fifth portion (35) and has an impurity concentration lower than an impurity concentration of the third semiconductor region (30).

## Description

Embodiments described herein relate generally to a semiconductor device and a method for manufacturing the same.

### BACKGROUND

Conventionally, planar MOSFETs and trench MOSFETs have been employed as structures of, for example, a power MOSFET (Metal-Oxide-Semiconductor Field Effect Transistor). Also, a so-called 3D MOSFET, in which the channel width of the MOSFET is provided in the depth direction of the substrate, has been considered. However, further improvement of the breakdown voltage is desirable for so-called 3D MOSFETs.

### BRIEF DESCRIPTION OF THE DRAWINGS

FIG. 1 is a schematic perspective view illustrating the configuration of a semiconductor device according to an embodiment;
FIG. 2 is a schematic perspective view illustrating a semiconductor device according to a reference example;
FIG. 3 is a schematic perspective view illustrating the state of the electric field of the semiconductor device according to the embodiment; and
FIG. 4A to FIG. 10B are schematic perspective views illustrating a method for manufacturing the semiconductor device according to the embodiment.

### DETAILED DESCRIPTION

According to one embodiment, a semiconductor device includes a first semiconductor region of a first conductivity type, a second semiconductor region of the first conductivity type, a third semiconductor region of a second conductivity type, a fourth semiconductor region of the first conductivity type, a gate region, a gate insulating film, and an electric field relaxation region of the second conductivity type. The first semiconductor region includes a first portion and a second portion. The first portion has a first major surface. The second portion extends in a first direction orthogonal to the first major surface. The second semiconductor region includes a third portion and a fourth portion. The third portion is provided on the first portion side and has a length shorter than a length of the second portion along the first direction. The fourth portion is adjacent to the second portion and extends in the first direction from a portion of an upper face of the third portion. The third semiconductor region includes a fifth portion and a sixth portion. The fifth portion is provided on the third portion side and has a length shorter than a length of the fourth portion along the first direction. The sixth portion is adjacent to the fourth portion and extends in the first direction from a portion of an upper face of the fifth portion. The fourth semiconductor region is provided on the fifth portion and adjacent to the sixth portion. The gate region is provided inside a trench made in a second direction orthogonal to the first direction in the second semiconductor region, the third semiconductor region, and the fourth semiconductor region. The gate insulating film is provided between the gate region and an inner wall of the trench. The electric field relaxation region is provided between the third portion and the fifth portion. The electric field relaxation region has an impurity concentration lower than an impurity concentration of the third semiconductor region.

According to another embodiment, a method is disclosed for manufacturing a semiconductor device. The method can include forming a first semiconductor region of a first conductivity type including a first portion and a second portion. The first portion has a first major surface. The second portion extends in a first direction orthogonal to the first major surface. The method can include covering the first semiconductor region with a second semiconductor region of the first conductivity type to form a third portion and a fourth portion. The third portion is provided on the first portion side and has a length shorter than a length of the second portion along the first direction. The fourth portion is adjacent to the second portion and extends in the first direction from a portion of an upper face of the third portion. The method can include forming an electric field relaxation region of a second conductivity type in a second major surface of the third portion. The second major surface opposes the first major surface. The method can include covering the second semiconductor region with a third semiconductor region of the second conductivity type to form a fifth portion and a sixth portion. The fifth portion is provided on the third portion side and has a length shorter than a length of the fourth portion along the first direction. The sixth portion is adjacent to the fourth portion and extends in the first direction from a portion of an upper face of the fifth portion. The method can include covering the third semiconductor region with a fourth semiconductor region of the first conductivity type. The method can include removing the fourth semiconductor region, the third semiconductor region, and the second semiconductor region until the second portion is exposed. In addition, the method can include making a trench in a second direction orthogonal to the first direction in the second semiconductor region, the third semiconductor region, and the fourth semiconductor region and forming a gate region inside the trench with a gate insulating film interposed.

Embodiments of the invention will now be described based on the drawings.

The drawings are schematic or conceptual; and the relationships between the thicknesses and widths of portions, the proportional coefficients of sizes among portions, etc., are not necessarily the same as the actual values thereof. Further, the dimensions and the proportional coefficients may be illustrated differently among the drawings, even for identical portions.

In the specification and the drawings of the application, components similar to those described in regard to a drawing thereinabove are marked with like reference numerals, and a detailed description is omitted as appropriate.

In the description hereinbelow, specific examples are illustrated in which silicon (Si) is used as an example of a semiconductor, a first conductivity type is an n type, and a second conductivity type is a p type. In the description hereinbelow, the notations of n⁺, n, n⁻, p⁺, p, and p⁻ indicate relative degrees of the impurity concentration of each of the conductivity types. In other words, n⁺ is an n-type impurity concentration relatively higher than n; and n⁻ is an n-type impurity concentration relatively lower than n. Also, p⁺ is a p-type impurity concentration relatively higher than p; and p⁻ is a p-type impurity concentration relatively lower than p.

### First embodiment

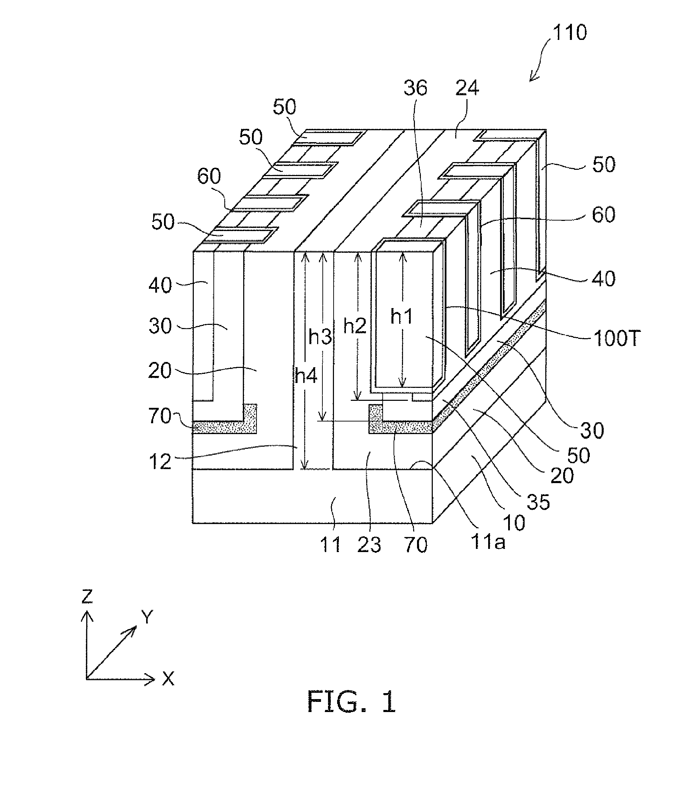

FIG. 1 is a schematic perspective view illustrating the configuration of a semiconductor device according to a first embodiment.

As illustrated in FIG. 1, the semiconductor device 110 according to the embodiment is a so-called 3D (three-dimensional) type in which the channel width of the MOSFET is provided along the depth direction of the substrate.

The semiconductor device 110 includes a first semiconductor region 10, a second semiconductor region 20, a third semiconductor region 30, a fourth semiconductor region 40, a gate region 50, a gate insulating film 60, and an electric field relaxation region 70.

The first semiconductor region 10 is a region of the first conductivity type including a first portion 11, which includes a first major surface 11a, and a second portion 12, which extends in a first direction orthogonal to the first major surface 11a.

In the embodiment, the first direction in which the second portion 12 extends is taken as a Z direction; one direction (a second direction) orthogonal to the first direction is taken as an X direction; and a third direction orthogonal to the first direction and the second direction is taken as a Y direction. For convenience of description in the embodiment, the direction in which the second portion 12 extends along the Z direction is taken as "up"; and the direction opposite thereto is taken as "down".

In the embodiment, the first semiconductor region 10 is an n⁺ drain region of, for example, a silicon wafer doped with phosphorus (P).

The second semiconductor region 20 is a region of the first conductivity type including a third portion 23 and a fourth portion 24.

The third portion 23 is provided on the first portion 11 with a length shorter than that of the second portion 12 along the Z direction. The fourth portion 24 is provided adjacent to the second portion 12 and extends in the Z direction from a portion of an upper face of the third portion 23.

In other words, the second semiconductor region 20 is provided with a substantially L-shaped configuration along the first portion 11 and the second portion 12 in the cross-sectional view of the XZ plane by the third portion 23 and the fourth portion 24 being provided in directions orthogonal to each other.

In the embodiment, the second semiconductor region 20 is a film formed by, for example, epitaxial growth on the surface of the first semiconductor region 10. The second semiconductor region 20 is an n⁻ drain region of, for example, an epitaxial film doped with phosphorus (P). The second semiconductor region 20 is used to form a drift region of the MOSFET.

The third semiconductor region 30 is a region of the second conductivity type including a fifth portion 35 and a sixth portion 36.

The fifth portion 35 is provided on the third portion 23 with a length shorter than that of the fourth portion 24 along the Z direction. The sixth portion 36 is provided adjacent to the fourth portion 24 and extends in the Z direction from a portion of an upper face of the fifth portion 35.

In other words, the third semiconductor region 30 is provided with a substantially L-shaped configuration along the third portion 23 and the fourth portion 24 in the cross-sectional view of the XZ plane by the fifth portion 35 and the sixth portion 36 being provided in directions orthogonal to each other.

A length h3 of the third semiconductor region 30 along the Z direction is shorter than a length h4 of the second semiconductor region 20 along the Z direction.

In the embodiment, the third semiconductor region 30 is a film formed by, for example, epitaxial growth on the surface of the second semiconductor region 20. The third semiconductor region 30 is a p⁻ base region of, for example, an epitaxial film doped with boron (B).

The fourth semiconductor region 40 is a region of the first conductivity type provided on the fifth portion 35 and adjacent to the sixth portion 36.

In other words, the fourth semiconductor region 40 is provided on the third semiconductor region 30 and extends in the Z direction. Thereby, the fourth semiconductor region 40 is filled onto the inner side of the substantially L-shaped configuration of the third semiconductor region 30 in the cross-sectional view of the XZ plane.

A length h2 of the fourth semiconductor region 40 along the Z direction is shorter than the length h3 of the third semiconductor region 30 along the Z direction.

In the embodiment, the fourth semiconductor region 40 is a film formed by, for example, epitaxial growth on the third semiconductor region 30. The fourth semiconductor region 40 is an n⁺ source region of, for example, an epitaxial film doped with phosphorus (P).

The gate region 50 is provided inside a trench 100T that pierces the second semiconductor region 20, the third semiconductor region 30, and the fourth semiconductor region 40 in the X direction.

In other words, the fourth portion 24 of the second semiconductor region 20, the sixth portion 36 of the third semiconductor region 30, and the fourth semiconductor region 40 are adjacent along the X direction. The trench 100T is provided to pierce the adjacent fourth portion 24, sixth portion 36, and fourth semiconductor region 40 along the X direction. The gate region 50 is filled inside the trench 100T with the gate insulating film 60 described below interposed.

The gate region 50 is provided inside the trench 100T and extends along the Z direction. The gate region 50 is provided with a length h1 along the Z direction. The length h1 is, for example, shorter than the length h2 of the fourth semiconductor region 40. Polycrystalline silicon, for example, may be used as the gate region 50.

The gate insulating film 60 is provided between the gate region 50 and an inner wall of the trench 100T. A silicon oxide film, for example, may be used as the gate insulating film 60.

The electric field relaxation region 70 is provided between the third portion 23 of the second semiconductor region 20 and the fifth portion 35 of the third semiconductor region 30. The electric field relaxation region 70 is a region of the second conductivity type having an impurity concentration lower than the impurity concentration of the third semiconductor region 30. The electric field relaxation region 70 is a p⁻ region of, for example, the third portion 23 doped with boron (B).

The electric field relaxation region 70 is provided from between the third portion 23 and the fifth portion 35 to a portion of the fourth portion 24. In other words, the electric field relaxation region 70 is provided around the outer side of the corner of the substantially L-shaped configuration of the third semiconductor region 30 in the cross-sectional view of the XZ plane. In the case where such an electric field relaxation region 70 is provided, an abrupt impurity concentration change between the p⁻-type third semiconductor region 30 and the n⁻-type second semiconductor region 20 is relaxed. In other words, in the semiconductor device 110 according to the embodiment, the electric field relaxation region 70 functions as a RESURF region to relax the electric field concentration around the corner of the substantially L-shaped configuration of the third semiconductor region 30.

In the semiconductor device 110 according to the embodiment, a channel is formed in the p- base region which is the third semiconductor region 30 adjacent to the gate insulating film 60 by applying an on-voltage to the gate region 50. In the semiconductor device 110, the length of the third semiconductor region 30 along the X direction corresponds to the channel length. In the semiconductor device 110, the depth h1 corresponding to the gate region 50 is the portion of the length of the third semiconductor region 30 along the Z direction that corresponds to the channel width. When the channel is formed in the entire third semiconductor region 30 in the channel length direction, a current flows from the fourth semiconductor region 40 which is the source region via the second semiconductor region 20 which is the drift region to the first semiconductor region 10 which is the drain region.

On the other hand, in the state in which the on-voltage is not applied to the gate region 50, the channel is not formed in the p- base region which is the third semiconductor region 30; and the current does not flow. Because the electric field relaxation region 70 is provided between the third semiconductor region 30 and the second semiconductor region 20 in the semiconductor device 110 according to the embodiment, a depletion layer reaches the electric field relaxation region 70 from the channel region. Thereby, the electric field concentration around the corner of the third semiconductor region 30 is relaxed; and the breakdown voltage can be increased.

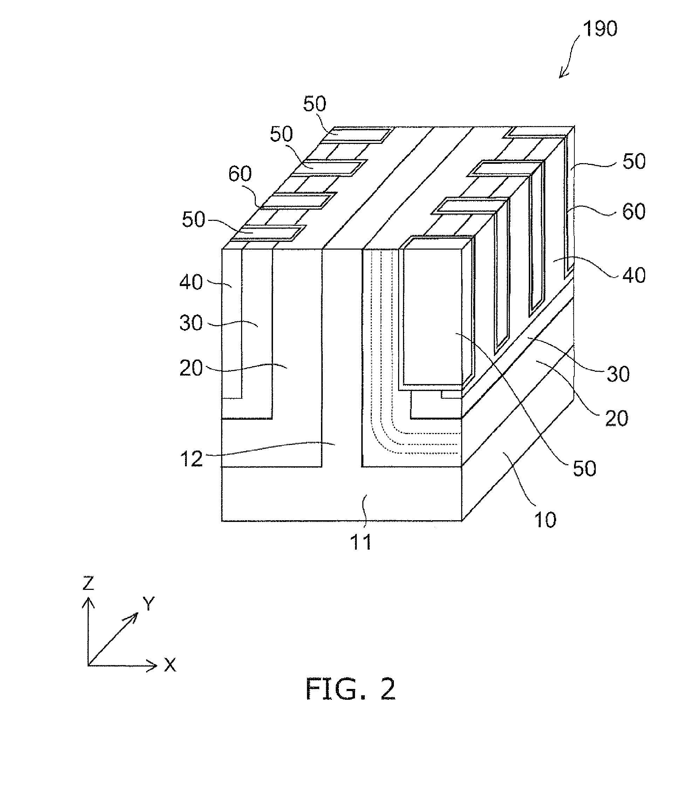

FIG. 2 is a schematic perspective view illustrating a semiconductor device according to a reference example.

As illustrated in FIG. 2, the semiconductor device 190 according to the reference example does not include an electric field relaxation region 70 such as that of the semiconductor device 110 illustrated in FIG. 1.

The broken lines of FIG. 2 illustrate the electric field applied between the third semiconductor region 30 and the second semiconductor region 20 when the MOSFET is in the off-state. In the semiconductor device 190, the electric field concentrates around the corner of the third semiconductor region 30.

In the semiconductor device 190, the first portion 11 and the second portion 12 of the first semiconductor region 10 are provided around two faces of the second semiconductor region 20 (the XY plane and the YZ plane). The third semiconductor region 30 is provided on inner sides of the second semiconductor region 20. Therefore, the third semiconductor region 30 contacts the second semiconductor region 20 at two orthogonal faces (the XY plane and the YZ plane). Thereby, the electric field concentrates easily at the corner of the third semiconductor region 30 between the two faces recited above.

It may be considered that the region from the fifth portion 35 of the third semiconductor region 30 toward the first portion 11 of the first semiconductor region 10 is equivalent to the terminal region of a so-called 3D-MOSFET. Therefore, the electric field concentrating around the corner of the third semiconductor region 30 between the two faces recited above is equivalent to a decrease of the breakdown voltage in the terminal region, which leads to a decrease of the breakdown voltage of the entire semiconductor device 190.

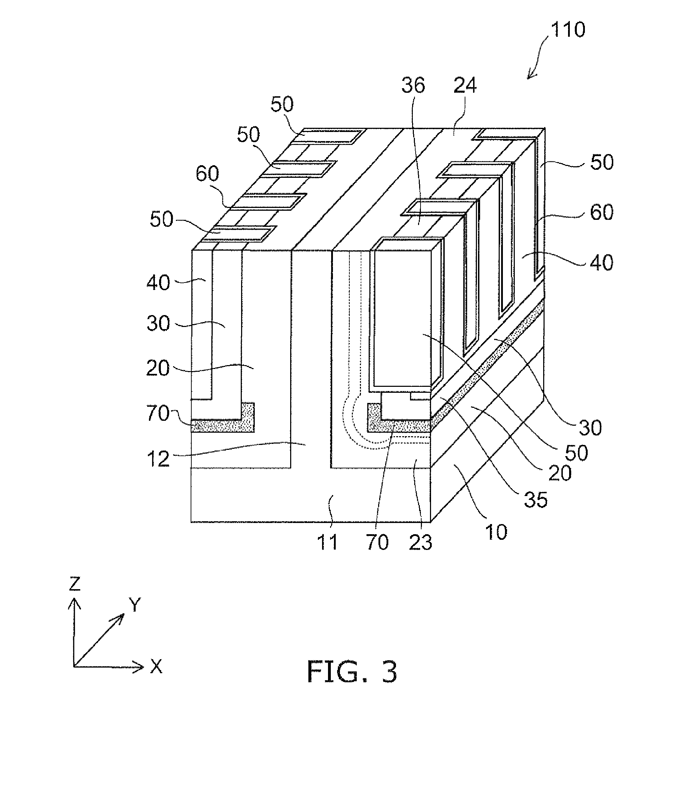

FIG. 3 is a schematic perspective view illustrating the state of the electric field of the semiconductor device 110 according to the embodiment.

The broken lines of FIG. 3 illustrate the electric field applied between the third semiconductor region 30 and the second semiconductor region 20 when the MOSFET of the semiconductor device 110 according to the embodiment is in the off-state.

Because the semiconductor device 110 according to the embodiment includes the electric field relaxation region 70 as described above, the electric field concentration between the third semiconductor region 30 and the second semiconductor region 20 is relaxed particularly around the corner of the third semiconductor region 30. Thereby, the breakdown voltage in the terminal region can be higher and the breakdown voltage of the entire semiconductor device 110 can be higher than those of the semiconductor device 190 according to the reference example illustrated in FIG. 2.

In the semiconductor device 110 illustrated in FIG. 1, the second portion 12 of the first semiconductor region 10 is provided extending along the Y direction. In the semiconductor device 110, the third semiconductor region 30 and the fourth semiconductor region 40 extend along the Y direction. In the semiconductor device 110, multiple gate regions 50 and multiple gate insulating films 60 are disposed along the Y direction.

Thereby, multiple MOSFET structures are provided corresponding to the second portion 12 extending in the Y direction. The gate regions of the multiple MOSFET structures are connected, for example, in parallel. The source regions of the multiple MOSFET structures are connected, for example, in parallel.

In the semiconductor device 110 illustrated in FIG. 1, the second semiconductor region 20, the third semiconductor region 30, the fourth semiconductor region, the multiple gate regions 50, and the multiple gate insulating films 60 are provided on both X-direction sides of the second portion 12.

In the semiconductor device 110, multiple second portions 12 may be disposed along the X direction; and these may include the multiple MOSFET structures provided on both X-direction sides of each of the second portions 12.

In such a semiconductor device 110 according to the embodiment, the breakdown voltage can be increased by the electric field concentration being relaxed around the corner of the third semiconductor region 30.

### Second embodiment

A second embodiment will now be described. The second embodiment is a method for manufacturing the semiconductor device according to the first embodiment.

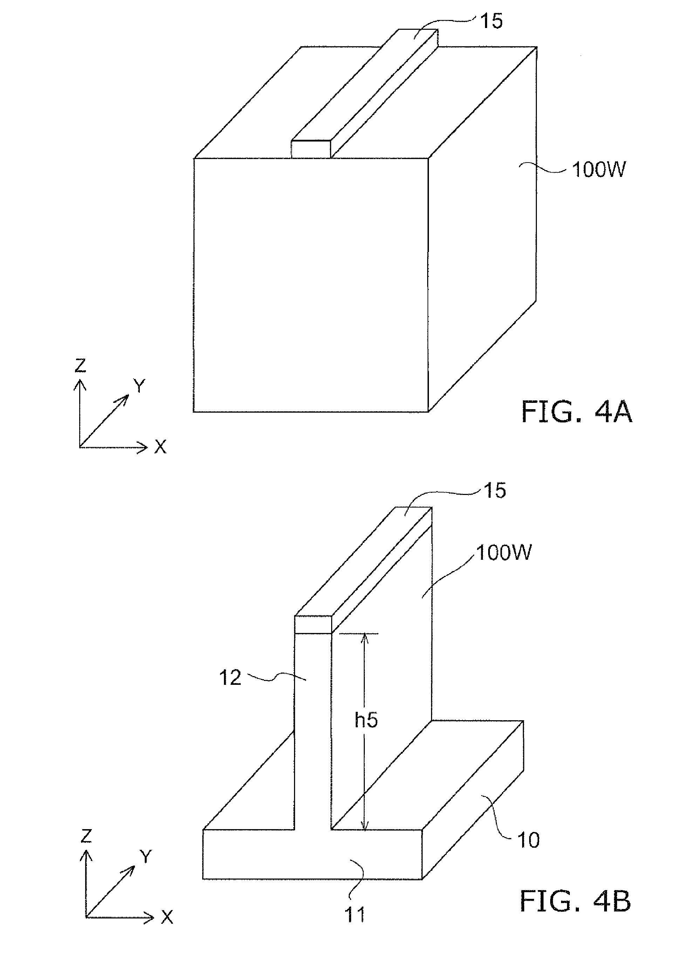

FIG. 4A to FIG. 10B are schematic perspective views illustrating the method for manufacturing the semiconductor device according to the first embodiment.

First, as illustrated in FIG. 4A, a wafer 10W of, for example, silicon is prepared. The wafer 10W is doped with, for example, phosphorus (P) to form the drain region which is the first semiconductor region 10; and the wafer 10W is n⁺. The impurity concentration of the wafer 10W is, for example, 4.5x 10¹⁹ cm⁻³_{.}

Then, for example, a silicon oxide film 15 is formed on the wafer 10W and patterned using photolithography and etching. Only the portion of the silicon oxide film 15 used to form the second portion 12 described below remains after the patterning.

Then, as illustrated in FIG. 4B, the wafer 10W is etched using the patterned silicon oxide film 15 as a mask. The etching is performed using, for example, RIE (Reactive Ion Etching). The etched portion of the wafer 10W remaining after the etching becomes the first portion 11. The portion masked by the silicon oxide film 15 and not etched becomes the second portion 12. Thereby, the first semiconductor region 10 including the first portion 11 and the second portion 12 is formed.

Here, the etching depth of the wafer 10W is, for example, 15 micrometers (µm) to 20 µm. Thereby, a length h5 of the second portion 12 along the Z direction is 15 µm to 20 µm.

After the wafer 10W is etched, the silicon oxide film 15 is removed.

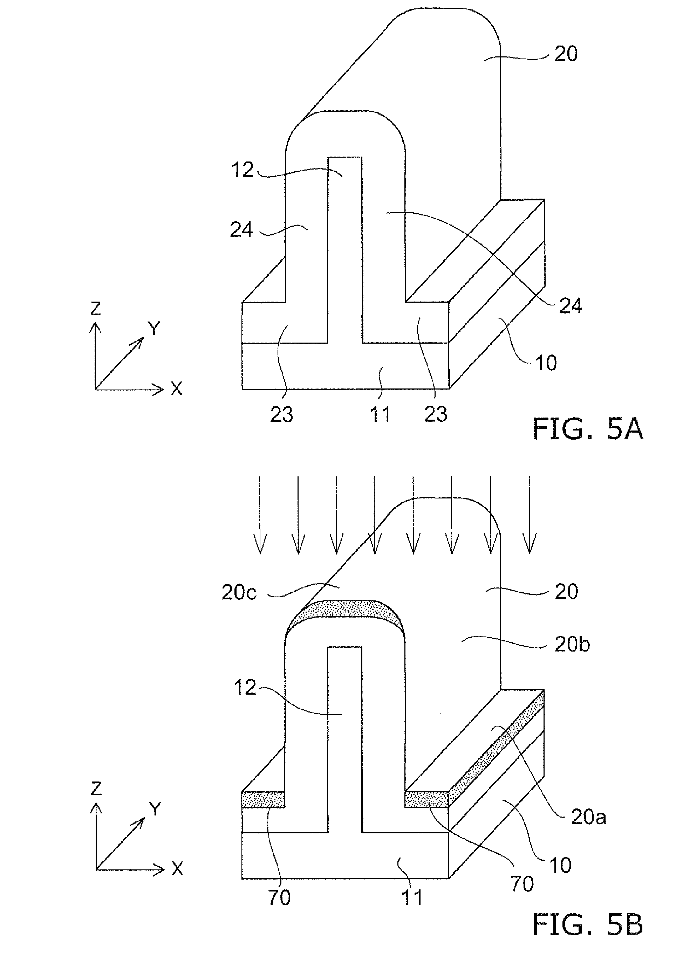

Then, as illustrated in FIG. 5A, the second semiconductor region 20 is formed as a film on the surface of the first semiconductor region 10. The second semiconductor region 20 is formed by, for example, epitaxial growth on the surface of the first semiconductor region 10. The second semiconductor region 20 is formed with a thickness of about 2 µm by the epitaxial growth. The second semiconductor region 20 is formed to cover the surfaces of the first portion 11 and the second portion 12 of the first semiconductor region 10. Thereby, the third portion 23 is formed on the first portion 11; and the fourth portion 24 is formed adjacent to the second portion 12.

After the epitaxial growth, the second semiconductor region 20 is doped with, for example, phosphorus (P). Thereby, the second semiconductor region 20 becomes an n- drain region. The impurity concentration of the second semiconductor region 20 is, for example, 2×10¹⁶ cm⁻³.

Then, as illustrated in FIG. 5B, ion implantation is performed from above the second semiconductor region 20. The ion implantation implants, for example, boron (B) ions as the impurity such that the second semiconductor region 20 is p⁻. Here, the boron (B) ions are implanted into an upper face 20c of the second semiconductor region 20 and a second major surface 20a of the second semiconductor region 20 opposing a first major surface 10a of the first semiconductor region 10. Thereof, the p- region due to the boron (B) implanted into the second major surface 20a becomes the electric field relaxation region 70.

The impurity concentration of the p- region (the electric field relaxation region 70) is lower than the impurity concentration of the third semiconductor region 30 formed subsequently. Here, for example, the boron is implanted with a dose of 1×10¹⁴ cm⁻². Thereby, the impurity concentration of the p⁻ region (the electric field relaxation region 70) is less than 1 × 10¹⁸ cm⁻³.

The incident angle of the ions of the ion implantation is an angle at which the ions are implanted into the second major surface 20a of the second semiconductor region 20 but are not implanted into a third major surface 20b of the second semiconductor region 20 opposing the side face of the second portion 12. The incident angle of the ions is, for example, about 3 degrees from a direction perpendicular to the second major surface 20a. Thereby, the ions that bombard the third major surface 20b of the second semiconductor region 20 are repelled; and the ions are implanted into the second major surface 20a without being implanted into the third major surface 20b. Although the impurity is implanted into the upper face 20c as well, this is removed by polishing in a subsequent process.

After implanting the impurity into the second semiconductor region 20, the impurity is diffused by heat treatment.

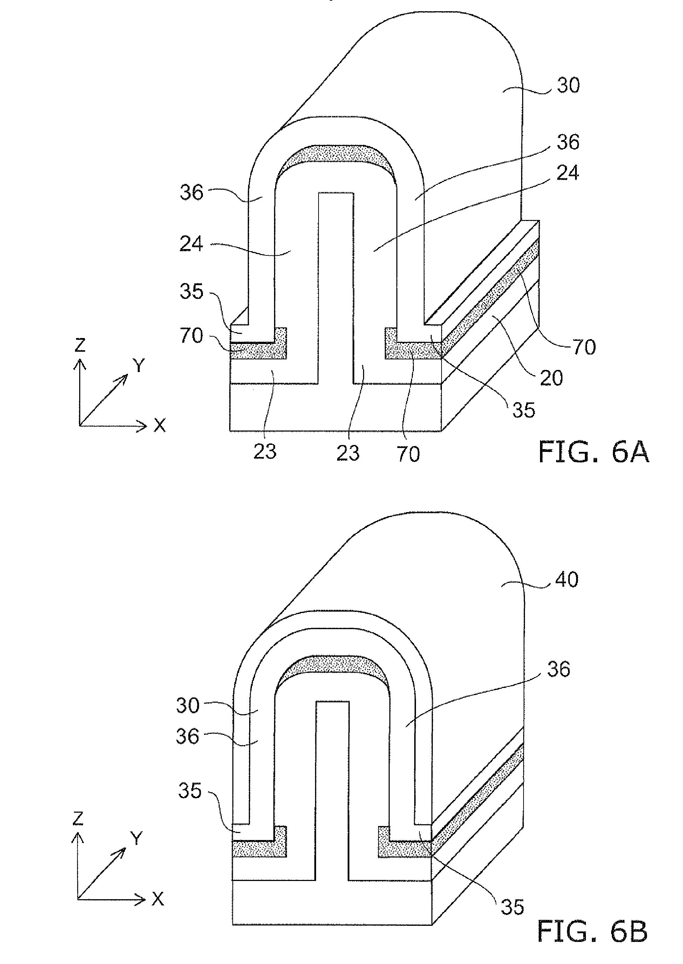

Then, as illustrated in FIG. 6A, the third semiconductor region 30 is formed as a film on the surface of the second semiconductor region 20. The third semiconductor region 30 is formed on the surface of the second semiconductor region 20 by, for example, epitaxial growth. The third semiconductor region 30 is formed with a thickness of about 0.35 µm by the epitaxial growth. Thereby, the fifth portion 35 is formed on the third portion 23; and the sixth portion 36 is formed adjacent to the fourth portion 24.

After the epitaxial growth, the third semiconductor region 30 is doped with, for example, boron (B) to become the p- base region. The impurity concentration of the third semiconductor region 30 is, for example, 1 × 10¹⁸ cm⁻³. In other words, the impurity concentration is higher than the impurity concentration of the electric field relaxation region 70 formed previously.

Then, as illustrated in FIG. 6B, the fourth semiconductor region 40 is formed as a film on the surface of the third semiconductor region 30. The fourth semiconductor region 40 is formed on the surface of the third semiconductor region 30 by, for example, epitaxial growth. The fourth semiconductor region 40 is formed with a thickness of about 0.55 µm by the epitaxial growth. Thereby, the fourth semiconductor region 40 is provided on the fifth portion 35 and adjacent to the sixth portion 36.

After the epitaxial growth, the fourth semiconductor region 40 is doped with, for example, phosphorus (P) to become the n⁺ source region. The impurity concentration of the fourth semiconductor region 40 is, for example, 3 × 10¹⁹ cm⁻³.

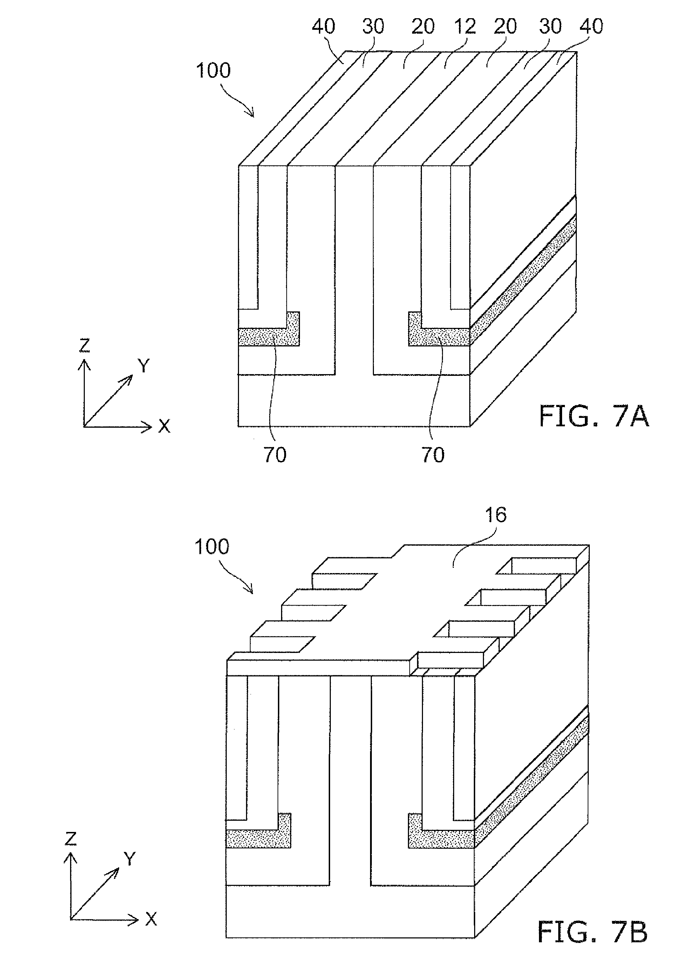

Then, as illustrated in FIG. 7A, the fourth semiconductor region 40, the third semiconductor region 30, and the second semiconductor region 20 are removed until the second portion 12 of the first semiconductor region 10 is exposed. The removal method may include, for example, CMP (Chemical Mechanical Polishing). A structural body 100, in which the exposed surface of the second portion 12 is planarized, is formed by the CMP.

Continuing as illustrated in FIG. 7B, a mask material 16 is formed on the structural body 100. The mask material 16 may include, for example, silicon oxide. The mask material 16 is formed using, for example, CVD (Chemical Vapor Deposition). After forming the mask material 16, patterning of the mask material 16 is performed using photolithography and etching. For example, a resist (not illustrated) is coated onto the mask material 16 and patterned using photolithography and etching. Subsequently, the mask material 16 is etched and patterned by, for example, RIE using the resist as a mask. In the patterning, openings are made in the mask material 16 only in the portions where the gate region 50 and the gate insulating film 60 are to be formed. After the patterning of the mask material 16, the resist is removed.

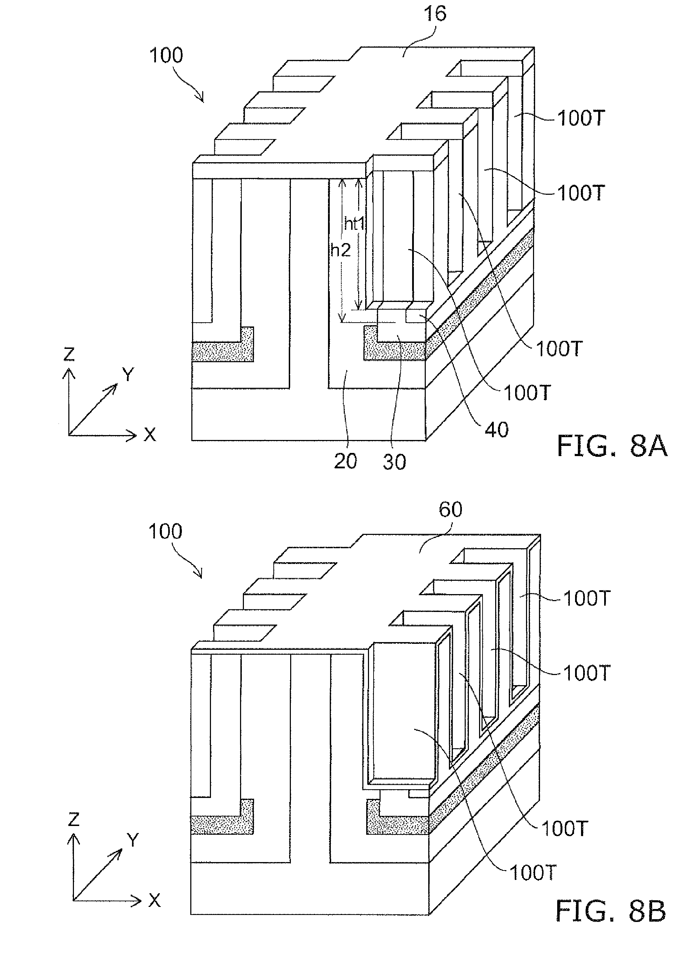

Then, as illustrated in FIG. 8A, the structural body 100 is etched using the patterned mask material 16 as a mask. By this etching, the structural body 100 at the opening portion of the mask material 16 is carved to make the trench 100T. The trench 100T is provided to pierce the second semiconductor region 20, the third semiconductor region 30, and the fourth semiconductor region 40 along the X direction. The trench 100T is made with a width of about 1 µm along the Y direction and a length ht1 of about 15 µm to 20 µm along the Z direction. In the embodiment, the length ht1 of the trench 100T along the Z direction is shorter than the length h2 of the fourth semiconductor region 40 along the Z direction. Multiple trenches 100T may be provided along the Y direction and the X direction as necessary.

After making the trench 100T, the mask material 16 is removed.

Then, as illustrated in FIG. 8B, the gate insulating film 60 is formed on the structural body 100 in which the trench 100T is made. The gate insulating film 60 is, for example, a silicon oxide film. The silicon oxide film may be formed by, for example, thermal oxidation. The gate insulating film 60 is formed with a thickness of, for example, 100 nanometers (nm).

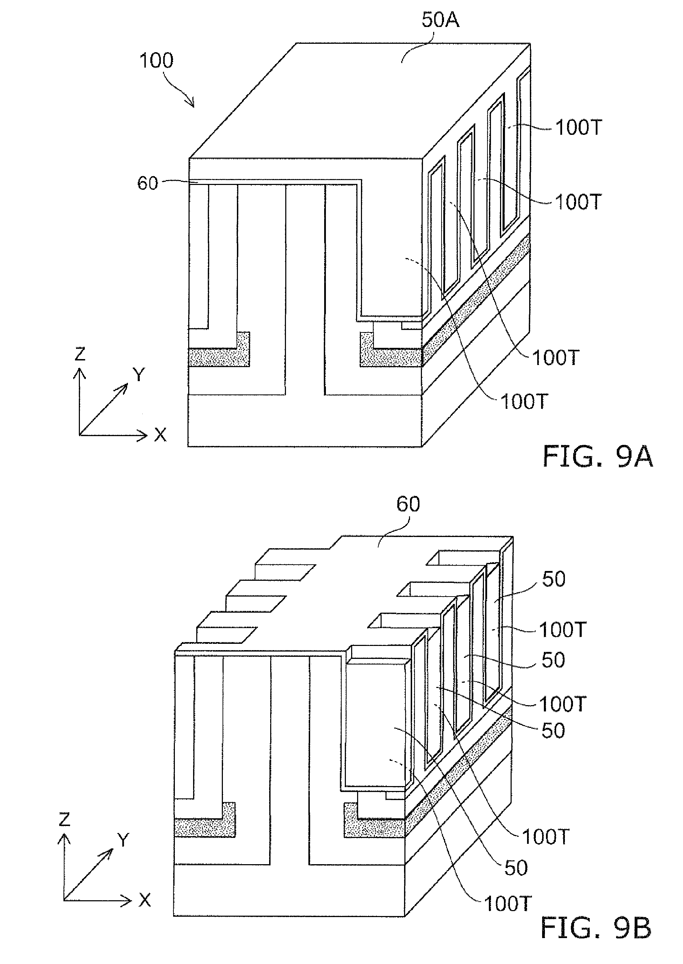

Continuing as illustrated in FIG. 9A, a gate material 50A is formed on the gate insulating film 60. The gate material 50A is, for example, polycrystalline silicon. The gate material 50A is filled onto the upper face of the structural body 100 and into the trench 100T.

Then, etch-back of the gate material 50A is performed. Thereby, as illustrated in FIG. 9B, the gate region 50 is provided inside the trench 100T with the gate insulating film 60 interposed. The upper face of the gate region 50 formed by the etch-back of the gate material 50A is slightly lower than the opening of the trench 100T along the Z direction.

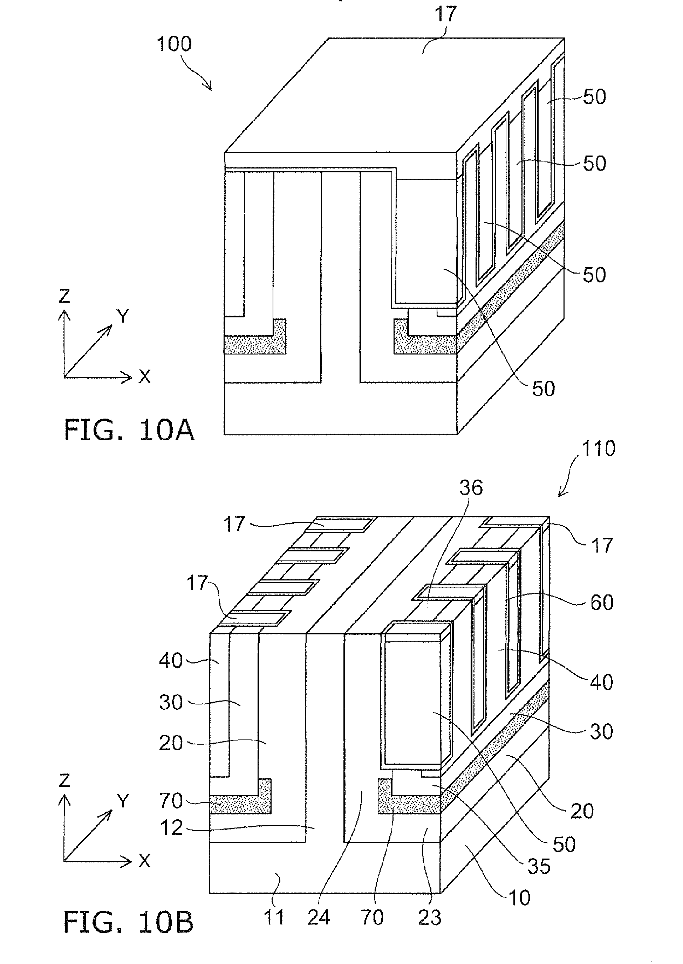

Continuing as illustrated in FIG. 10A, an inter-layer insulating film 17 is formed on the structural body 100. The inter-layer insulating film 17 is formed on the entire surface of the upper face of the structural body 100. Subsequently, the inter-layer insulating film 17 is etched using, for example, RIE. This etching is performed until the second portion 12, the second semiconductor region 20, the third semiconductor region 30, and the fourth semiconductor region 40 are exposed as illustrated in FIG. 10B. Thereby, the inter-layer insulating film 17 remains on the gate region 50.

Subsequently, not-illustrated electrodes (the gate electrode, the drain electrode, and the source electrode) are formed to be electrically connected to the gate region 50, the drain region which is the first semiconductor region 10, and the source region which is the fourth semiconductor region 40. The electrodes may include, for example, aluminum (Al). The electrodes undergo the prescribed patterning using photolithography and etching. Subsequently, a protective film (not illustrated) such as, for example, polyimide is formed. Thereby, the semiconductor device 110 is completed.

According to such a second embodiment, the electric field relaxation region 70 is included between the third semiconductor region 30 and the second semiconductor region 20; and it is possible to manufacture the semiconductor device 110 having a relaxed electric field concentration and a higher breakdown voltage.

Although the first conductivity type is the n type and the second conductivity type is the p type in the description of the embodiments described above, the invention is practicable also when the first conductivity type is the p type and the second conductivity type is the n type. Further, although a MOSFET using silicon (Si) as the semiconductor is described in the embodiments described above, a compound semiconductor such as, for example, silicon carbide (SiC) or gallium nitride (GaN) or a wide bandgap semiconductor such as diamond may be used as the semiconductor.

Furthermore, although an example of a MOSFET is illustrated in the embodiments and the modifications described above, the invention is not limited thereto. The semiconductor device may be, for example, a device combining a MOSFET and a SBD (Schottky Barrier Diode) or a device such as an IGBT (Insulated Gate Bipolar Transistor).

As described above, according to the embodiment, the breakdown voltage of the semiconductor device can be increased.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A semiconductor device(110) comprising:
a first semiconductor region(10) of a first conductivity type including a first portion(11) and a second portion(12), the first portion having a first major surface(11a), the second portion(12) extending in a first direction orthogonal to the first major surface(11a);
a second semiconductor region(20) of the first conductivity type including a third portion(23) and a fourth portion(24), the third portion(23) being provided on the first portion side and having a length shorter than a length of the second portion along the first direction, the fourth portion(24) being adjacent to the second portion and extending in the first direction from a portion of an upper face of the third portion;
a third semiconductor region(30) of a second conductivity type including a fifth portion(35) and a sixth portion(36), the fifth portion(35) being provided on the third portion side and having a length shorter than a length of the fourth portion(24) along the first direction, the sixth portion(36) being adjacent to the fourth portion(24) and extending in the first direction from a portion of an upper face of the fifth portion(35);
a fourth semiconductor region(40) of the first conductivity type provided on the fifth portion(35) and adjacent to the sixth portion(36);
a gate region(50) provided inside a trench(100T) made in a second direction orthogonal to the first direction in the second semiconductor region(20), the third semiconductor region(30), and the fourth semiconductor regions(40);
a gate insulating film(60) provided between the gate region(50) and an inner wall of the trench(100T); and
an electric field relaxation region(70) of the second conductivity type provided between the third portion and the fifth portion(35), the electric field relaxation region(70) having an impurity concentration lower than an impurity concentration of the third semiconductor region(30).

2. The device(110) according to claim 1, wherein the second portion is provided extending in a third direction orthogonal to the first direction and the second direction.

3. The device(110) according to claim 2, wherein a plurality of the gate regions(50) and a plurality of the gate insulating films(60) are provided along the third direction.

4. The device(110) according to any of claims 2 and 3, wherein the second semiconductor region(20), the third semiconductor region(30), and the fourth semiconductor region(40) extend along the third direction.

5. The device(110) according to any of claims 1-4, wherein a first length(h1) of the gate region(50) along the first direction is shorter than a second length(h2) of the fourth semiconductor region(40) along the first direction.

6. The device(110) according to any of claims 1-5, wherein a second length(h2) of the fourth semiconductor region(40) along the first direction is shorter than a third length(h3) of the third semiconductor region(30) along the first direction.

7. The device(110) according to any of claims 1-6, wherein a third length(h3) of the third semiconductor region(30) along the first direction is shorter than a fourth length(h4) of the second semiconductor region(20) along the first direction.

8. The device(110) according to any of claims 1-7, wherein the electric field relaxation region(70) is provided from between the third portion and the fifth portion(35) to a portion of the fourth portion(24).

9. The device(110) according to claim 8, wherein the electric field relaxation region(70) is provided around an outer side of a corner of a substantially L-shaped configuration of the third semiconductor region(30).

10. The device(110) according to any of claims 1-9, wherein the electric field relaxation region(70) is a RESURF region.

11. A method for manufacturing a semiconductor device(110), comprising:
forming a first semiconductor region(10) of a first conductivity type including a first portion(11) and a second portion, the first portion having a first major surface(11a), the second portion extending in a first direction orthogonal to the first major surface(11a);
covering the first semiconductor region(10) with a second semiconductor region(20) of the first conductivity type to form a third portion and a fourth portion(24), the third portion being provided on the first portion side and having a length shorter than a length of the second portion along the first direction, the fourth portion(24) being adjacent to the second portion and extending in the first direction from a portion of an upper face of the third portion;
forming an electric field relaxation region(70) of a second conductivity type in a second major surface of the third portion, the second major surface opposing the first major surface(11a);
covering the second semiconductor region(20) with a third semiconductor region(30) of the second conductivity type to form a fifth portion(35) and a sixth portion(36), the fifth portion(35) being provided on the third portion side and having a length shorter than a length of the fourth portion(24) along the first direction, the sixth portion(36) being adjacent to the fourth portion(24) and extending in the first direction from a portion of an upper face of the fifth portion(35);
covering the third semiconductor region(30) with a fourth semiconductor region(40) of the first conductivity type;
removing the fourth semiconductor region(40), the third semiconductor region(30), and the second semiconductor region(20) until the second portion is exposed; and
making a trench(100T) in a second direction orthogonal to the first direction in the second semiconductor region(20), the third semiconductor region(30), and the fourth semiconductor region(40) and forming a gate region(50) inside the trench(100T) with a gate insulating film(60) interposed.

12. The method according to claim 11, wherein the forming of the electric field relaxation region(70) includes implanting ions of an impurity used to form the second conductivity type into the second major surface.

13. The method according to claim 12, wherein an incident angle of the ions is an angle to implant the ions into the second major surface while not implanting the ions into a third major surface of the fourth portion(24), the third major surface opposing a side face of the second portion.

14. The method according to claim 12, wherein the impurity is diffused by heat treatment after the implanting the ions of the impurity.

15. The method according to any of claims 11-14, wherein a second length of the fourth semiconductor region(40) along the first direction is made shorter than a third length of the third semiconductor region(30) along the first direction.

16. The method according to any of claims 11-15, wherein a third length of the third semiconductor region(30) along the first direction is made shorter than a fourth length of the second semiconductor region(20) along the first direction.
